**Europäisches Patentamt**

**European Patent Office**

**Office européen des brevets**

(11) Numéro de publication: **0 101 409**
**B1**

# FASCICULE DE BREVET EUROPEEN

(45) Date de publication du fascicule du brevet:
19.11.87

(21) Numéro de dépôt: 83810323.2

(22) Date de dépôt: 15.07.83

(51) Int. Cl.⁴: **H 05 K 3/42**

(54) **Circuit imprimé et procédé de fabrication du circuit.**

(30) Priorité: 16.07.82 CH 4352/82

(43) Date de publication de la demande:
22.02.84 Bulletin 84/8

(45) Mention de la délivrance du brevet:
19.11.87 Bulletin 87/47

(84) Etats contractants désignés:
DE FR GB IT

(56) Documents cités:
DE - A - 1 811 377
US - A - 3 702 284
US - A - 3 772 101

IBM TECHNICAL DISCLOSURE BULLETIN, vol. 13, no. 1,
juin 1970, page 181, New York, US; R.H.MEAD:
"Landless plated through-hole process"

(73) Titulaire: CIRTECH S.A., 94, rue de Lausanne,
CH-1202 Genève (CH)

(72) Inventeur: Strobel, Jean-Paul, CH-1249 Avully (CH)

(74) Mandataire: Mohnhaupt, Dietrich et al, DIETLIN,
MOHNHAUPT & Cie S.A. Rue des Epinettes 19,
CH-1227 Genève (CH)

ACTORUM AG

## Description

L'invention a pour objet un circuit imprimé comprenant des pistes conductives sur un support en matière isolante et des trous à parois conductives traversant le support en contact électrique avec au moins une des pistes conductives.

Une modification de l'invention concerne un circuit imprimé du genre décrit, comprenant des trous de fixation qui ne sont en contact avec aucune piste conductive.

Des circuits imprimés du genre décrit sont connus en électronique et électricité. Ils servent à la réalisation de circuits électroniques et électriques pour tous les usages dans ce domaine. Le support en matière isolante sert à la fois au montage des composants du circuit, tels que résistances, condensateurs, semi-conducteurs, circuits intégrés, etc., et à la connexion désirée de ces composants au moyen des pistes conductives qu'il porte sur au moins une de ses surfaces et qui connectent les composants les uns aux autres.

Le support peut être une plaque en matière isolante telle que Bakélite®, résine époxy etc., d'une épaisseur de 0,1 à 6 mm par exemple; il peut également être constitué par une feuille en matière plastique souple ou semi-rigide. Les pistes conductives sont généralement réalisées en cuivre ou en un alliage de cuivre et peuvent être étamées, argentées, dorées etc.

La fabrication des circuits imprimés est connue en soi. On part d'un support isolant laminé par une feuille de cuivre, d'une épaisseur allant de 5 à 100 microns habituellement, d'autres épaisseurs étant possibles pour des cas spéciaux, on recouvre cette couche de cuivre d'un dessin correspondant aux connections entre les composants à monter, et l'on enlève le cuivre aux endroits voulus par un procédé de gravure chimique, le cuivre étant oxydé et dissous sous forme de sel. Des réactifs de gravure sont par exemple des solutions aqueuses de chlorure ferrique, ou de perchlorate ou de persulfate d'ammonium.

Les nouveaux développements dans ce domaine visent à supprimer le laminage de cuivre et de former les pistes directement sur le support isolant par métallisation, selon le dessin voulu.

Les trous nécessaires au montage des composants et, le cas échéant, à la connexion d'une piste sur une face avec une piste sur l'autre face, peuvent être forés à n'importe quel stade du procédé. Ces trous sont métallisés pour assurer le contact entre les pistes de faces différentes au cas de circuits à double face. La métallisation des trous est donc connue en soi; elle peut être réalisée par des techniques familières à l'homme du métier depuis une dizaine d'années, comprenant par exemple l'application au circuit percé et bien nettoyé, d'une solution aqueuse de PdCl$_2$ puis de couches métalliques y compris une couche principale de cuivre, par dépôt galvanique.

On a déjà proposé, dans le brevet U.S.A. No. 3 772 101 et dans «IBM Technical Disclosure Bulletin, Vo. 13, No. 1, p. 181, des trous sans couronne. Le brevet cité décrit un procédé de formation de trous de contactage sans couronne dans des circuits imprimés, le procédé étant conduit de façon à ce que le diamètre des trous du masque utilisé comme résist de gravure, est le même que le diamètre du trou dans le circuit. Cette caractéristique crée de sérieux problèmes d'alignement, et en tout cas, on obtient un circuit comprenant une protubérance ou saillie du dépôt galvanique autour des trous, par rapport à la surface du support isolant. Une autre mise en œuvre propose l'utilisation du circuit foré comme masque photo ce qui demande, entre autres, l'application d'un photorésist positif. En pratique, ceci est à l'origine de problèmes de confusion car pour tout autre travail, on utilise des photorésists négatifs, et en plus, il faut irradier le circuit en formation depuis les deux côtés, par deux étapes successives; le procédé de reproduction de l'image du circuit comprend alors deux étapes de masquage et quatre étapes d'irradiation. On ne décrit pas de fabrication de trous traversants de montage ou de fixation; pour la définition de termes «montage», «contactage» et «fixation», voir ci-dessous.

On a estimé nécessaire que chaque trou soit entouré en surface de métal acceptant la soudure afin d'assurer une liaison de soudure sûre entre la piste et le fil de connexion d'un composant, par exemple l'ergot («pin») d'un circuit intégré. Ce métal est en général une pastille ou couronne, de préférence étamée; l'entourage métallique du trou peut aussi être réalisé par la piste elle-même si sa largeur est plus grande que le diamètre du trou. La présence d'une couronne autour de chaque trou a été considérée, jusqu'à ce jour, comme indispensable car on avait constaté des défaillances de liaison métallique entre la piste et la métallisation du trou; seule la couronne a donné la sûreté nécessaire d'un bon contact. En plus, la couronne doit assurer une surface de prise de soudure suffisamment grande pour retenir le composant en place et assurer un contact électrique approprié.

Pour plus de clarté, on donne maintenant les définitions des termes les plus importants usités ici: «trou de contactage» désigne un trou à paroi métallisée servant de liaison d'au moins une piste, sur un circuit à double face ou à multicouches, avec au moins une autre piste sur une autre face du même support ou d'un autre support; «trou de montage» est un trou à paroi métallisée servant de réception et de soudure d'un fil ou pin d'un composant extérieur, ce trou étant en contact avec au moins une piste conductive, et «trou de fixation» est un trou de montage mais sans contact avec une piste conductive. «Etain» et «étamé» ne sont pas limités à l'étain pur mais comprennent également tous les alliages de soudure contenant l'étain (par exemple, Sn-Pb, Sn-Pb-Cu; Sn-Pb-Ag; Sn-Pb-Ag-Cu, etc.)

Le développpement de l'électronique vers la miniaturisation nécessite une densité toujours croissante de pistes et de composants sur un circuit imprimé. On doit utiliser, de plus en plus, la place disponible sur un circuit. La technique actuelle permet, par exemple, le passage d'une ou de deux pistes entre les pastilles de trous pour circuits intégrés. Les trous, d'un diamètre de 0,8 mm par exemple, ont une distance entre eux de 2,54 mm ce qui laisse environ 1,1 mm de distance entre les couronnes de deux trous si ces couronnes ont une largeur de 0,3 mm. Ceci est l'optimum à obtenir par la technique actuelle.

L'Offenlegungsschrift allemand no. 1 811 377, publiée le 18.6.1970, prétend comme avantage la possibilité d'utiliser des trous sans couronnes comme trous de montage mais ne décrit pas une telle utilisation.

Afin d'augmenter la densité des circuits, on a proposé l'utilisation de circuits imprimés dits multicouches où deux ou plusieurs circuits à double face sont réunis sous pression par des fils de connexion verticalement soudés dans des trous correspondants alignés. Une telle technique est très compliquée car l'alignement de plusieurs trous est extrêmement difficile, et elle n'est guère utilisée à cause du prix très élevé.

L'invention se propose de développer un nouveau circuit imprimé dont la réalisation permet de supprimer les limitations décrites et d'augmenter, dans une mesure estimée comme absolument impossible jusqu'à maintenant, la densité et la définition des pistes des circuits simple face et double face. Cette densité accrue est particulièrement avantageuse dans les circuits du matériel logiciel et informatique car ces circuits sont constitués de très peu de composants discrets, toutes les fonctions étant assurées par des circuits intégrés. Or, ces circuits intégrés doivent être connectés par un très grand nombre de pistes formant des «bus».

Le circuit selon l'invention, sa modification et un procédé pour sa réalisation sont définis dans les revendications indépendantes tandis que les modes d'exécution particuliers font l'objet des revendications dépendantes.

L'invention sera maintenant expliquée plus en détail. Il est d'abord à souligner que le fait qu'on supprime les couronnes de soudure est absolument surprenant vu l'importance attribuée à ces couronnes jusqu'ici. On a donc dû trouver une technique pour rendre la liaison entre la piste et la métallisation du trou sûre et fiable. En plus, on a trouvé de manière pas moins surprenante, que la soudure d'un composant extérieur peut être réalisée sans couronne, c'est-à-dire avec l'intérieur du trou seulement. La fiabilité de cette soudure est augmentée par une métallisation améliorée.

A part certaines étapes critiques, la fabrication d'un nouveau circuit imprimé peut se faire selon les différentes méthodes connues. Afin de mieux illustrer l'invention, on décrira ci-après le déroulement d'un procédé préféré de fabrication du circuit imprimé objet de l'invention. Il est clair pour l'homme du métier que la succession de certaines étapes peut être inversée, que des étapes peuvent être répétées ou supprimées, etc.

La description qui suivra se réfère au dessin dans lequel:

— la fig. 1 montre une vue en plan partielle et fortement agrandie d'une plaque en voie de préparation,

— la fig. 2 est une couple selon la ligne II–II de la fig. 1,

— la fig. 3 est une coupe semblable à la fig. 2, mais après gravure, et

— la fig. 4 montre le trou des fig. 2 et 3 après la soudure d'un composant.

On se procure d'abord le matériel de départ, par exemple une plaque isolante comprenant, sur au moins une de ses faces, un laminé de feuille de cuivre. Bien que les plaques «double face» et les feuilles de matière plastique (polyester) simple face et double face peuvent également être utilisées, la description suivante sera faite relative à une plaque solide «simple face», pour raison de simplicité mais nullement pour une raison de limitation. Comme on a déjà dit ci-dessus, même des supports non cuivrés peuvent être utilisés.

Les couches de cuivre ont généralement une épaisseur de 35 microns environ, mais elles peuvent cependant être plus minces, par exemple 15 microns. L'épaisseur de 5 microns est recommandée pour les circuits de très haute définition.

Après les travaux de préparation d'usage, à savoir la coupe, le nettoyage etc., on effectue le perçage du circuit. On perce normalement les trous pour composants, y compris les ergots de circuits intégrés, avec un diamètre de 0,8 mm tandis que les trous de contactage (circuits à double face ou multiface) auront un diamètre inférieur, par exemple 0,3 ou 0,4 mm ou même inférieur. Le perçage s'effectue selon un pochoir modèle, ou bien de préférence à l'aide d'une perceuse à commande numérique. Tous les trous peuvent évidemment être aussi du même diamètre.

Il est préférable que le perçage soit conduit de façon précise et apte à produire un trou absolument prismatique (normalement cylindrique) et absolument net et propre, sans bavures et avec les bords bien francs.

Les plaques ainsi percées sont maintenant métallisées au moins sur les parois des trous, normalement sans courant par une technique appelée «flash» chimique. Le bain de métallisation est normalement appliqué partout, et l'on obtient comme résultat une plaque dont toutes les surfaces, y compris celles de l'intérieur des trous, sont revêtues d'une fine couche de métal de base. Il suffit cependant de métalliser les trous seulement.

On place maintenant par laminage un photoresist sous forme de film sur la plaque. Ce photoresist peut être obtenu selon les techniques connues de l'homme du métier, par voie photochimique. Le photoresist couvre toute la plaque sauf les endroits où le cuivre de base doit rester, à savoir les pistes. Les trous préalablement forés sont partiellement couverts par le photoresist de façon que les bords des trous sont complètement cachés sous le photoresist qui peut, de préférence s'étendre même au-delà des bords, par 0,1 mm par exemple.

La prochaine étape est le cuivrage galvanique de la plaque masquée. Ce cuivrage sert à charger la mince couche métallique déposée dans les trous pour produire une bonne couche conductrice. Inévitablement, du cuivre se dépose également sur les autres endroits non masqués, notamment les pistes.

Sur la couche de cuivre ainsi déposée, d'une épaisseur de quelque 20 à 30 microns, est maintenant déposé un alliage d'étain et de plomb. L'homme du métier sait que ces métaux peuvent être déposés simultanément à partir d'un bain aqueux acide contenant les fluoborates de ces métaux. Le rapport pondéral Sn:Pb peut être influencé, dans certaines limites, par la composition du bain.

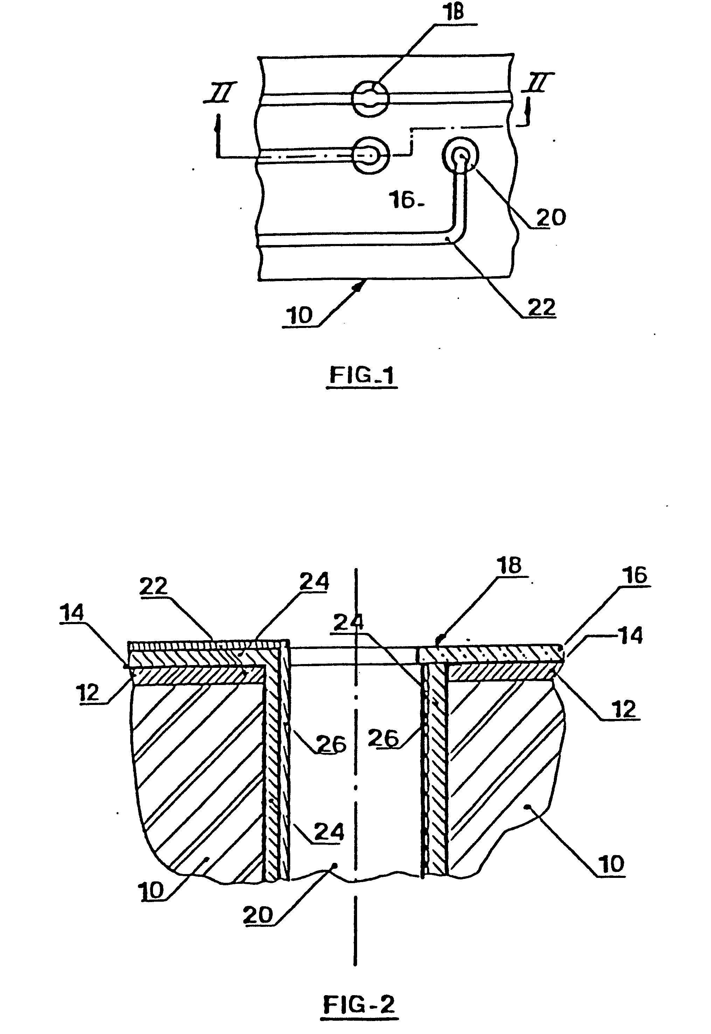

Une fois l'étamage-plombage finie, la plaque se présente selon les fig. 1 et 2. La plaque isolante 10 qui constitue le support, comporte la couche de base 12 en cuivre laminé. Toutes les surfaces sont recouvertes de la fine couche de métallisation primaire 14. Cette couche de métallisation 14 est partiellement masquée par le photoresist 16 dont une partie 18 fait saillie sur le bord du trou 20 sauf là où il aura la piste 22 qui sera en connection électrique parfaite avec les parois du trou 20. La couche de cuivre galvanique 24 et sa surcouche d'étain-plomb 26 recouvrent toutes les surfaces sauf où se trouve le photoresist 16.

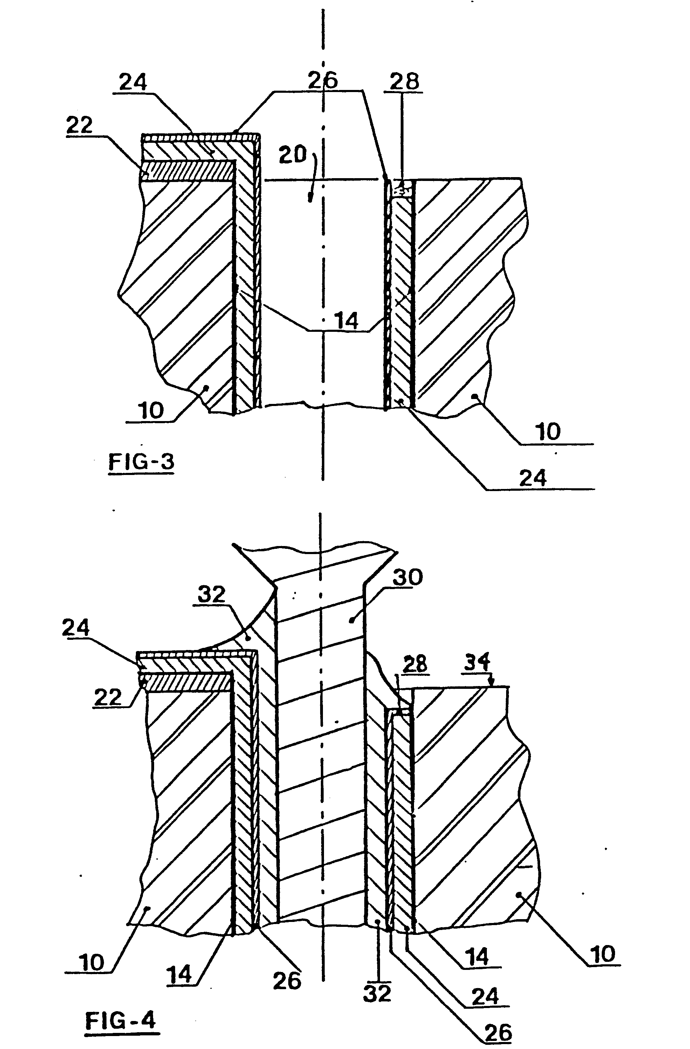

On peut maintenant enlever le photoresist 16 et soumettre la plaque à la gravure. On dissout les parties du cuivre nu, à savoir qui ne sont pas protégées par l'alliage étain-plomb (couche 26) qu'on doit d'ailleurs chauffer après la gravure afin de supprimer les porosités du dépôt galvanique et de former et d'homogénéiser l'alliage. La plaque se présente alors, dessinée en coupe analogue à la fig. 2, dans l'état représenté à la fig. 3. La couche de cuivre de base 12 a disparu mais également la partie supérieure 28 de la couche 24 de cuivre galvanique dans le trou 20 qui n'était pas protégée par l'étain-plomb. La partie supérieure annulaire du trou est donc exempte de cuivre, et la hauteur de cet anneau «libre» est environ égale à l'épaisseur des couches de base 12 enlevées par la gravure. Lorsque l'épaisseur des pistes est faible ou sous certaines conditions de gravure, la hauteur de cet anneau peut être négligeable, voire nulle, de façon que la couche 24 dans l'intérieur du trou s'étend jusqu'à la surface du support.

On peut protéger la surface de cet anneau libre de cuivre contre l'oxydation par un étamage supplémentaire à chaud qui a pour effet de recouvrir d'étain-plomb ou d'étain, selon la matière utilisée, la couche 24, au moins à l'intérieur des trous. Cette condition est exprimée à la fig. 3 par les lignes pointillées, en ce qui concerne le rebord supérieur de la couche 24 dans le trou 20.

Une étape qui est conseillée de supprimer est le brossage de la plaque qu'on recommande jusqu'à maintenant après la métallisation. On a trouvé que ce brossage introduit plutôt des poussières et autres contaminants au lieu de les enlever. Une couche de métallisation sans brossage semble garantir une meilleure adhérence.

La plaque est maintenant prête au montage des composants suivi de la soudure à la vague à une température voisine de 220 °C.

Il va de soi que toutes les étapes du procédé doivent être exécutées aux conditions les plus propres possibles; tous les bains aqueux, les métaux en fusion etc. seront maintenus purs et sans particules étrangères.

Finalement, la fig. 4 montre le trou des fig. 2 et 3 après la soudure d'un ergot 30 d'un composant. On voit que la soudure 32 ne souille pas la surface non cuivrée 34 de la plaque 10. On peut utiliser un masque de soudure mais ceci n'est pas nécessaire dans la plupart des cas.

En général, le diamètre des trous de montage des composants est plus grand ou au plus égal à la largeur des pistes. En d'autres termes, on fait les pistes de préférence plus étroites que le diamètre des trous. Cette mesure contribue à la propreté de la soudure, à savoir pour que la surface 34 du support reste exempte de soudure.

L'invention permet d'obtenir une densité de pistes jamais vue jusqu'à ce jour. Par exemple, il est possible de faire passer huit pistes bien distinctes et définies entre les deux trous successifs d'un circuit intégré, d'un diamètre de 0,8 mm et d'une distance entre axes de 2,54 mm, donc sur une largeur de 1,74 mm sans que les pistes touchent les ergots du C.I. On a pu placer 22 pistes à côté sur une largeur de 6 mm. Ces densités et cette résolution n'étaient de loin pas possibles avant l'invention.

L'invention est particulièrement avantageuse lors de la construction des circuits multicouches.

Naturellement, la plaque peut être traitée par toutes les méthodes de finition, comme nettoyage, vernissage etc.

On a constaté que le trou sans couronne de soudure selon l'invention ne présente pas de défaillances de contact ni de corrosion. On pense que ce résultat est dû au dépôt galvanique de cuivre sur les parois du trou et en même temps sur la piste qui doit être en contact avec le trou. De manière surprenante, les composants soudés sont fermement tenus en place comme si la couronne était présente.

Un mode de réalisation important, à savoir une modification, de l'invention est la fabrication de trous traversants sans pastilles qui ne sont pas en contact avec une piste conductive. Le but de cette modification est la possibilité de souder des fils, pins et pattes de fixation de composants extérieurs ou n'importe quels fils, par exemple des circuits intégrés, pour les tenir solidement en place, ou pour contribuer à cette action. Un avantage de cette technique est le fait que, lors de la soudure, la surface libre du substrat isolant n'est pas souillée par la soudure car elle n'a pas de réceptivité dû à l'absence de pastilles.

## Revendications

1. Circuit imprimé, comprenant des pistes conductives sur un support en matière isolante et des trous qui traversent le support et dont les parois sont conductives et en contact électrique avec au moins une des pistes conductives, les trous étant destinés à la soudure des fils ou ergots des composants à fixer sur le circuit, caractérisé en ce que le circuit est exempt de couronnes de soudure, que les parois des trous (20) présentent une couche de cuivre galvaniquement déposée (24) qui peut également couvrir au moins une partie des pistes (22), et que la couche de cuivre couvrant la paroi du trou se termine au niveau ou au-dessous de la surface du support sur toute la circonférence de trou hormis la largeur de la piste (22) avec laquelle cette couche est en contact.

2. Circuit selon la revendication 1, caractérisé en ce que les pistes (22) sont moins larges que le diamètre des trous (20).

3. Circuit selon la revendication 1, caractérisé en ce qu'un alliage d'étain-plomb recouvre au moins une partie de la surface cuivrée du circuit, allant de la couche du cuivre dans le trou (20) jusqu'à la totalité de la surface cuivrée du circuit (22).

4. Circuit selon l'une des revendications précédentes, caractérisé en ce que le support comporte des pistes sur ses deux faces.

5. Circuit selon l'une des revendications 1 à 3, caractérisé en ce que le support comporte des pistes sur l'une de ses deux faces.

6. Circuit selon l'une des revendications 1 à 4, caractérisé en ce que le diamètre des trous de montage est d'environ 0,8 mm, et le diamètre des trous de contactage est plus petit que 0,8 mm, par exemple compris entre 0,3 et 0,4 mm.

7. Circuit selon l'une des revendications précédentes, caractérisé en ce que la hauteur de la paroi du trou exempte de cuivre équivaut à l'épaisseur de la piste non galvanisée.

8. Circuit imprimé, comprenant des pistes conductives sur un support en matière isolante et des trous qui traversent le support et dont les parois sont conductives, y inclus des trous de fixation destinés à l'insertion et la soudure de composants à fixer sur le dit circuit, caractérisé en ce que ces trous de fixation comprennent des parois métallisées où la couche de métal couvrant la paroi du trou se termine au niveau ou au-dessous de la surface du support sur toute la circonférence du trou, les trous n'étant en contact électrique avec aucune des dites pistes conductives.

9. Procédé de fabrication par masquage et gravure d'un circuit imprimé selon l'une quelconque des revendications précédentes, caractérisé par les étapes suivantes:

(a) perçage des trous parfaits et précis, sans bavures, dans un support de matière isolante et laminé ou non sur au moins une des faces avec une couche de cuivre, selon un dessin prédéterminé,

(b) métallisation sans courant d'au moins des parois des trous,

(c) masquage du circuit selon un dessin prédéterminé, le masque dépassant les bords des trous vers l'intérieur,

(d) dépôt galvanique d'une couche de cuivre au moins sur les parois des trous et les parties des pistes aboutissant aux trous,

(e) application d'un masque de gravure protégeant les parties du circuit qui doivent rester, et

(f) gravure du circuit.

10. Procédé selon la revendication 9, caractérisé en ce que le circuit gravé est soumis à un étamage à chaud à partir d'un bain fondu de métal, au moins sur les parois des trous.

11. Procédé selon la revendication 9, caractérisé en ce que l'étape (e) consiste en un dépôt galvanique simultané d'étain et de plomb à partir d'une solution aqueuse de leurs sels.

**Claims**

1. A printed circuit board having conductor paths on a supporting substrate of insulating material, and through holes traversing said substrate and having conductive inner walls which are in electric contact with at least one of the conductor paths, the holes being designed for receiving leads or pins of the components to be connected to the circuit board, characterised in that the circuit board is free from soldering lands, in that the inner walls of the holes (20) are covered by an electrically plated copper layer (24) which optionally covers also at least part of the conductor paths (22), and in that the copper layer covering the inner wall of the hole ends at a location being at level or below the level of the surface plane of said substrate over the entire circumference of the hole excepted the width of the conductor path (22) with which said copper layer is in contact.

2. The printed circuit board of claim 1, characterised in that the paths (22) are narrower than the diameter of the holes (20).

3. The printed circuit board of claim 1, characterised in that at least a portion of the copper layer on the printed circuit, from the copper layer in the hole (20) to the whole coppered surface (22) of the circuit board, is covered by a tin-lead alloy.

4. The printed circuit board of any one of the preceding claims, characterised in that the supporting substrate carries conductor paths on its both sides.

5. The printed circuit board of any one of claims 1 to 3, characterised in that the supporting substrate carries conductor paths on one of its both sides.

6. The printed circuit board of any one of claims 1 to 4, characterised in that the diameter of the mounting holes is about 0.8 mm and the diameter of interconnecting holes is inferior to 0.8 mm, for instance between 0.3 and 0.4 mm.

7. The printed circuit board of any one of the preceding claims, characterised in that the height of the inner wall of the hole free from copper is substantially equal to the thickness of the non covered conductor paths.

8. A printed circuit board, having conductor paths on a supporting substrate of insulating material, and through holes traversing said substrate and having conductive inner walls, including mounting holes designed for inserting and soldering of components to be fixed on said circuit board, characterised in that said mounting holes have metalplated walls, that the plating layer covering the inner wall of the holes ends at a location being at level or below the level of the surface plane of said substrate over the entire circumference of the hole, said mounting holes having no electric contact with any of said conductor paths.

9. A method for making a printed circuit board according to any one of the preceding claims by masking and etching, characterised by the following steps:

(a) drilling perfect and precise through holes, free from burrs, in a supporting substrate of insulating material, laminated or not on at least one of its sides with a copper layer, according to a predeterminated pattern,

(b) electroless metallising of at least the inner walls of the drilled holes,

(c) masking of the circuit board according to a predeterminated pattern, the mask overlapping the edges of the drilled holes towards their inner walls,

(d) applying a copper layer by electroplating at least on the walls of the holes and on the portions of the paths leading to the holes,

(e) applying an etching mask to protect the portions of the circuit board, which must finally remain thereon, and

(f) etching the circuit.

10. The method of claim 9, characterised in that the etched circuit is heat tinned from a molten metal bath at least the inner walls of the holes.

11. The method of claim 9, characterised in that the step (e) consists in electroplating with a tin-lead alloy by simultaneously depositing these metals from an aqueous solution of their salts.

**Patentansprüche**

1. Gedruckte Schaltung mit Leiterbahnen auf einem Träger aus Isoliermaterial und mit Löchern, die den Träger durchdringen, deren Wandungen leitend sind und in elektrischem Kontakt mit mindestens einer Leiterbahn stehen, und die zum Einlöten von Drähten oder Stiften der auf der Schaltung anzubringenden Bauteile bestimmt sind, dadurch gekennzeichnet, dass die Schaltung frei von Lötaugen ist, dass die Lochwandungen (20) mit einer galvanisch aufgebrachten Kupferschicht (24) versehen sind, die auch mindestens einen Teil der Leiterbahnen (22) bedecken kann, und dass die Kupferschicht auf der Lochwandung in Höhe oder unterhalb der Trägeroberfläche auf dem gesamten Umfang des Loches endet, mit Ausnahme der Breite der Leiterbahn (22), mit der diese Kupferschicht in Kontakt ist.

2. Gedruckte Schaltung nach Anspruch 1, dadurch gekennzeichnet, dass die Leiterbahnen (22) schmaler als der Durchmesser der Löcher (20) sind.

3. Gedruckte Schaltung nach Anspruch 1, dadurch gekennzeichnet, dass mindestens ein Teil der verkupferten Schaltungsoberfläche von einer Zinn-Blei-Legierung bedeckt ist, nämlich mindestens die Lochwandungen (20) bis zur gesamten verkupferten Schaltungsfläche (22).

4. Gedruckte Schaltung nach einem der vorstehenden Ansprüche, dadurch gekennzeichnet, dass der Träger beidseitig Leiterbahnen aufweist.

5. Gedruckte Schaltung nach einem der Ansprüche 1 bis 3, dadurch gekennzeichnet, dass der Träger auf einer Seite Leiterbahnen aufweist.

6. Gedruckte Schaltung nach einem der Ansprüche 1 bis 4, dadurch gekennzeichnet, dass der Durchmesser der Bestückungslöcher etwa 0,8 mm und der Durchmesser der Verbindungslöcher kleiner als 0,8 mm ist, beispielsweise 0,3 bis 0,4 mm.

7. Gedruckte Schaltung nach einem der vorstehenden Ansprüche, dadurch gekennzeichnet, dass die Höhe der kupferfreien Lochwandung der Dicke der ungalvanisierten Leiterbahn entspricht.

8. Gedruckte Schaltung mit Leiterbahnen auf einem Träger aus Isoliermaterial und mit Löchern, die den Träger durchsetzen und deren Wandungen leitend sind, einschliesslich Montagelöchern für die Aufnahme und Verlötung von Bauteilen, die auf der Schaltung zu befestigen sind, dadurch gekennzeichnet, dass die Montagelöcher metallisierte Wandungen aufweisen, bei denen die Metallschicht, welche die Lochwandung bedeckt, in Höhe der Trägeroberfläche oder darunter über dem gesamten Lochumfang endet, wobei die Löcher mit keiner Leiterbahn in elektrischem Kontakt stehen.

9. Verfahren zur Herstellung der gedruckten Schaltung nach einem der vorstehenden Ansprüche durch Maskierung und Ätzung, gekennzeichnet, durch folgende Schritte:

(a) Anbringung perfekter, präziser und gratfreier Bohrungen in einem Isolierstoffträger, der gegebenenfalls mindestens einseitig mit einer Kupferlage laminiert ist, nach einem vorgegebenen Muster,

(b) stromlose Metallisierung mindestens der Lochwandungen,

(c) Maskierung der Schaltung nach einem vorgegebenen Muster, wobei die Maske die Lochränder in Richtung des Lochinneren überdeckt,

(d) galvanisches Abscheiden einer Kupferschicht mindestens auf den Lochwandungen und Bereichen von Leiterbahnen, die am Loch enden,

(e) Aufbringen eines Ätzresists zum Schutz der zu verbleibenden Schaltungsbereiche, und

(f) Ätzung der Schaltung.

10. Verfahren nach Anspruch 9, dadurch gekennzeichnet, dass die geätzte Schaltung mittels einer Metallschmelze mindestens auf den Lochwandungen hitzeverzinnt wird.

11. Verfahren nach Anspruch 9, dadurch gekennzeichnet, dass der Schritt (e) aus einer gleichzeitigen galvanischen Abscheidung von Zinn und Blei aus einer wässrigen Lösung von Salzen dieser Metalle besteht.

**FIG.1**

**FIG-2**

FIG-3

FIG-4